# EUROPÄISCHE PATENTSCHRIFT

(11) **EP 1 889 133 B1**
(45) Veröffentlichungstag und Bekanntmachung des Hinweises auf die Patenterteilung: **04.02.2009**
(21) Anmeldenummer: 07723766.7
(22) Anmeldetag: 29.03.2007
(51) Int. Cl.: G05D 23/19, G01R 31/28

(54) **VERFAHREN UND VORRICHTUNG ZUM TEMPERIEREN VON ELEKTRONISCHEN BAUELEMENTEN**
METHOD AND DEVICE FOR TEMPERING ELECTRONIC COMPONENTS
PROCÉDÉ ET DISPOSITIF DE RÉGULATION THERMIQUE DE COMPOSANTS ÉLECTRONIQUES

(30) Priorität: 03.04.2006 DE 102006015365
(43) Veröffentlichungstag der Anmeldung: 20.02.2008
(73) Patentinhaber: Multitest elektronische Systeme GmbH, 83026 Rosenheim (DE)
(72) Erfinder: SCHAULE. Maximilian, 87719 Mindelheim (DE); BAUER, Alexander, 83026 Rosenheim (DE); KURZ, Stefan, 83026 Rosenheim (DE); ASCHL, Franz, 83346 Bergen (DE)
(74) Vertreter: Bauer, Friedrich
(86) Internationale Anmeldenummer: PCT/EP2007/002824
(87) Internationale Veröffentlichungsnummer: WO 2007/115699

(56) Entgegenhaltungen:
- WO-A-02/35169
- WO-A-02/097342
- DE-A1- 10 120 631
- US-A- 4 918 928

## Beschreibung

Die Erfindung betrifft ein Verfahren und eine Vorrichtung zum Temperieren von elektronischen Bauelementen innerhalb eines Handlers für einen Funktionstest gemäß dem Oberbegriff des Anspruches 1 bzw. 4.

Elektronische Bauelemente in der Form von Halbleiterbausteinen werden während oder nach ihrer Fertigung meist einem besonderen Funktionstest unter bestimmten Temperaturen unterzogen. Der Temperaturbereich, in dem die Bauelemente getestet werden, kann beispielsweise von -60°C bis +170°C betragen. Es ist somit erforderlich, die Bauelemente entsprechend abzukühlen oder zu erwärmen. Die Bauelemente können während des Testvorgangs in Einzelform oder im Verbund (Strips, Lead Frames) vorliegen.

Die Temperierung der Bauelemente wird üblicherweise in einem sogenannten Handler, d.h. einem Handhabungsautomaten für elektronische Bauelemente, durchgeführt, der hierzu eine Temperaturkammer, in der die Bauelemente auf die gewünschte Temperatur vortemperiert werden, sowie eine Testkammer aufweist, in der sich ein Kontaktiernest ("Chuck") befindet, das die Bauelemente beim Aufsetzen einer von außen zugeführten Kontaktiervorrichtung in der gewünschten Kontaktierposition hält. Der Transport der Bauelemente von der Temperaturkammer zum Kontaktiernest erfolgt dabei mittels einer speziellen Transportvorrichtung (Pick and Place Einheit).

Es ist bekannt, die Bauelemente in der Temperaturkammer, im Bereich der Transportvorrichtung sowie in der Testkammer auf rein konvektive Weise im Umluft- und Verwirbelungsverfahren zu temperieren, wobei ein entsprechend temperiertes Gas in die Temperatur- und Testkammer eingeleitet wird. Dies kann im Falle von Niedertemperaturtests entweder durch Verdampfen von flüssigem Stickstoff in der Temperaturkammer unter Nutzung der Verdampfungsenthalpie oder durch externe Kühlaggregate erfolgen, wobei im geschlossenen Umluftverfahren ein Luftstrom durch die Temperaturkammer gespült wird und im externen Kühlaggregat mittels Wärmepumpe gekühlt wird. In beiden Fällen handelt es sich um Volumenströme im Niederdruckbereich.

Dieses bekannte Verfahren hat jedoch den Nachteil, dass alle temperierten Bereiche des Handlers in aufwendiger Weise isoliert werden müssen, um einerseits eine genaue Temperierung der Bauelemente zu erreichen und andererseits Schäden an den Maschinenkomponenten im Heiß- oder Kaltbetrieb zu verhindern. Ein besonderes Problem stellt insbesondere die Kondensation an den Kammerwänden sowie die Vereisung an kritischen Stellen, beispielsweise den Kontaktstellen, bei Kalttests dar. Weiterhin sind Systeme mit rein konvektiver Temperierung relativ träge, so dass die Temperierungsgeschwindigkeiten häufig zu wünschen übrig lassen.

Um diese Nachteile zu vermeiden, ist man vereinzelt dazu übergegangen, nicht mehr mit Temperaturkammern zu arbeiten, sondern nur mehr wenige entscheidende Stellen innerhalb des Handlers zu heizen oder zu kühlen (Hot/Cold-Spot-Temperierung). So ist es bekannt, Bauelemente, die noch im Strip-Verbund zusammenhängen, auf ein Kontaktiernest zu legen, das entsprechend temperiert ist und die Bauelemente rein konduktiv temperiert. Auch dort sind die Temperierungszeiten jedoch nicht unerheblich. Um dies zu verkürzen, werden bekanntermaßen vorausgehende "Soak-Stationen" verwendet, die als Heiz- oder Kühlplatten ausgebildet sind und ebenfalls durch reinen konduktiven Wärmeübergang die Bausteine vortemperieren. Die Heizung der Platten erfolgt dabei bekanntermaßen mittels elektrischer Heizungen oder mittels eines flüssigen Mediums, das durch ein externes Kühl- oder Heizaggregat entsprechend abgekühlt oder aufgeheizt wird.

Obwohl mit der konduktiven Temperierung ein effektiverer Wärmeübergang zum elektronischen Bauelement als bei der konvektiven Temperierung möglich und ein weit geringerer Isolierungsaufwand erforderlich ist, hat die konduktive Temperierung insbesondere den Nachteil, dass inhomogene, unterschiedliche Wärmeübergänge von den Platten zu den Bauelementen vorhanden sind und daher die Temperaturverteilung über die Bausteine zum Teil sehr inhomogen und ungenau ist. Weiterhin ist ein paralleles konduktives Temperieren mehrerer Strips sehr aufwendig. Bei der Temperierung mit einem flüssigen Medium, bei dem üblicherweise spezielle Öle verwendet werden, besteht das Risiko einer Leckage und das Problem, dass entsprechende Öle meist nur bis -40°C verfügbar sind. Weiterhin unterliegen die Bauelemente innerhalb sehr kurzer Zeit einer starken Temperaturänderung, was zu einer ungewöhnlich hohen thermischen Belastung der Bauelemente führen kann.

Aus der US 4,918,928 A ist ein Verfahren und eine Vorrichtung gemäß dem Oberbegriff des Anspruches 1 bzw. 4 bekannt, bei dem bzw. der Halbleiterelemente in einer Vorbehandlungskammer und Nachbehandlungskammer konvektiv vor- bzw. nachtemperiert werden. In einer Testkammer werden die Bauelemente sowohl direkt konduktiv als auch konvektiv auf die gewünschte Testtemperatur gebracht. Weiterhin wird dort der Gasdruck in den Vorbehandlungs- und Nachbehandlungskammern sowie in der Testkammer geringfügig über dem Umgebungsdruck gehalten, wodurch das Eindringen von Umgebungsluft in diese Kammern verhindert werden soll. Durch eine derartige Maßnahme kann jedoch bei Handhabungsautomaten, die auf Geschwindigkeit optimiert sind und ein hohes Transportaufkommen in die Behandlungskammern und in die Testkammer aufweisen, das Eindringen von feuchter oder verunreinigter Umgebungsluft in die Behandlungskammern und Testkammer nicht ausreichend vermieden werden, da es zu Mitführeffekten durch die gehandhabten Bauelemente kommt.

Weiterhin ist aus der DE 10 2004 002 707 A1 ein Verfahren und eine Vorrichtung zum Temperieren von elektronischen Halbleiterbauelementen für einen Funktionstest bekannt, wobei die zu testenden Bauelemente mittels eines Gases vortemperiert und durch gezieltes Anströmen mit temperiertem Gas auf Testtemperatur gebracht werden.

Der Erfindung liegt die Aufgabe zugrunde, ein Verfahren und eine Vorrichtung der eingangs genannten Art zu schaffen, mit dem bzw. der das Temperieren von elektronischen Bauelementen auf möglichst einfache, kostengünstige, schnelle und genaue Weise durchgeführt und das Eindringen von Umgebungsluft in die Temperatur- und Testkammer auch bei schnell arbeitenden Handhabungsautomaten besonders zuverlässig verhindert werden kann.

Diese Aufgabe wird erfindungsgemäß durch ein Verfahren mit den Merkmalen des Anspruches 1 und mit einer Vorrichtung gemäß den Merkmalen des Anspruches 4 gelöst. Vorteilhafte Ausgestaltungen der Erfindung sind in weiteren Ansprüchen beschrieben.

Beim erfindungsgemäßen Verfahren wird der Gasdruck innerhalb der Testkammer höher als der Gasdruck innerhalb der Temperaturkammer gehalten. Weiterhin werden der Einlass und der Auslass der Temperaturkammer abwechselnd geoffnet und geschlossen, so dass eine unidirektionale Gasströmung von der Testkammer in die Temperaturkammer und von dieser in die Umgebung stattfindet.

Dadurch, dass der Gasdruck innerhalb der Testkammer höher als der Gasdruck innerhalb der Temperaturkammer und der Gasdruck innerhalb der Temperaturkammer höher als der Umgebungsdruck gehalten wird, wird eine unidirektionale Gasströmung von der Testkammer in die Temperaturkammer und von dieser in die Umgebung auf besonders zuverlässige Weise auch bei schnell arbeitenden Handhabungsautomaten mit hohen Durchsätzen gewährleistet. Unidirektional bedeutet hierbei, dass das Gas ausschließlich von der Testkammer in Richtung Temperaturkammer und von dort in die Umgebung, und nicht in umgekehrter Richtung, strömt. Die kontinuierliche Durchflutung mit trockenem Gas verhindert auf wirkungsvolle Weise eine Vereisung im Kontaktierbereich sowie Kondensationsvorgänge an den Kammerwänden bei Tieftemperaturtests.

Der Einlass und Auslass der Temperaturkammer werden abwechselnd geöffnet und geschlossen, d.h. der Einlass und Auslass, über den die Bauelemente in die Temperaturkammer eingeführt bzw. aus dieser entfernt werden, werden nicht gleichzeitig geöffnet. Hierdurch wird sichergestellt, dass trockenes Gas immer aus der Temperaturkammer nach außen abströmt und niemals feuchte Luft in die Temperaturkammer und von dort in die Testkammer eindringen kann.

Weiterhin wird eine spezielle Kombination einer konvektiven Temperierung der Bauelemente innerhalb einer Temperaturkammer und einer Hot/Cold-Spot-Temperierung in der Testkammer verwendet, wobei die Bauelemente dort konduktiv oder durch direktes Anströmen mit temperiertem Gas gezielt auf die gewünschte Testtemperatur gebracht und auf dieser gehalten werden.

Gegenüber einem rein konvektiven Temperierungsverfahren bietet das erfindungsgemäße Verfahren insbesondere den Vorteil, dass der Isolierungsaufwand bedeutend verringert wird, da nur die Temperaturkammer, nicht jedoch die Testkammer in umfangreicher Weise isoliert werden muss. Der Platzbedarf für die Testkammer ist daher wesentlich geringer. Weiterhin ist ein modulares Konzept leichter zu verwirklichen als bei einem rein konvektiven Verfahren, da bei Einsatz eines rein konvektiven Verfahrens die Maschinen je nach Anwendung immer wieder neu konstruiert werden müssen. Die Möglichkeit des modularen Konzepts führt zu Vorteilen bei der Planung, der Erweiterung und der Umrüstung des Systems.

Gegenüber dem rein konduktiven Verfahren bietet das erfindungsgemäße Verfahren den Vorteil, dass die Bauteile bereits sehr gut vortemperiert sind, wenn sie zur Testkammer gelangen. Es erfolgen keine extrem großen oder schnellen Temperaturänderungen, so dass die thermische Belastung für die Bauelemente wesentlich geringer ist. Der Temperaturübergang und die Temperaturverteilung über mehrere Bauelemente eines Streifens ist wesentlich homogener und gleichförmiger. Verwerfungen der die Bauelemente enthaltenden Streifen können daher vermieden werden. Weiterhin ermöglicht das erfindungsgemäße Verfahren ein sehr schnelles und genaues Temperieren der Bauelemente.

Gemäß einer vorteilhaften Ausführungsform wird in die Testkammer zusätzlich trockenes Gas eingeleitet, das zweckmäßigerweise aus getrockneter Umgebungsluft besteht. Hierdurch wird die Gefahr einer Kondensation im Testkammerbereich vermieden oder zumindest wesentlich verkleinert. Da das zugeführte trockene Gas in der Testkammer Umgebungstemperatur haben kann, werden außerdem die Antriebsmechanik für das Kontaktiernest und die Transporteinrichtung für die Bauelemente keinen thermischen Belastungen ausgesetzt.

Die erfindungsgemäße Vorrichtung bietet die gleichen Vorteile, wie im Zusammenhang mit dem Verfahren geschildert.

Die Erfindung wird nachfolgend anhand der Zeichnungen beispielhaft näher erläutert. Es zeigen:
- Figur 1:: eine schematische Draufsicht auf die erfindungsgemäße Vorrichtung, und
- Figur 2:: eine schematische Darstellung zur Verdeutlichung des Kontaktiernests.

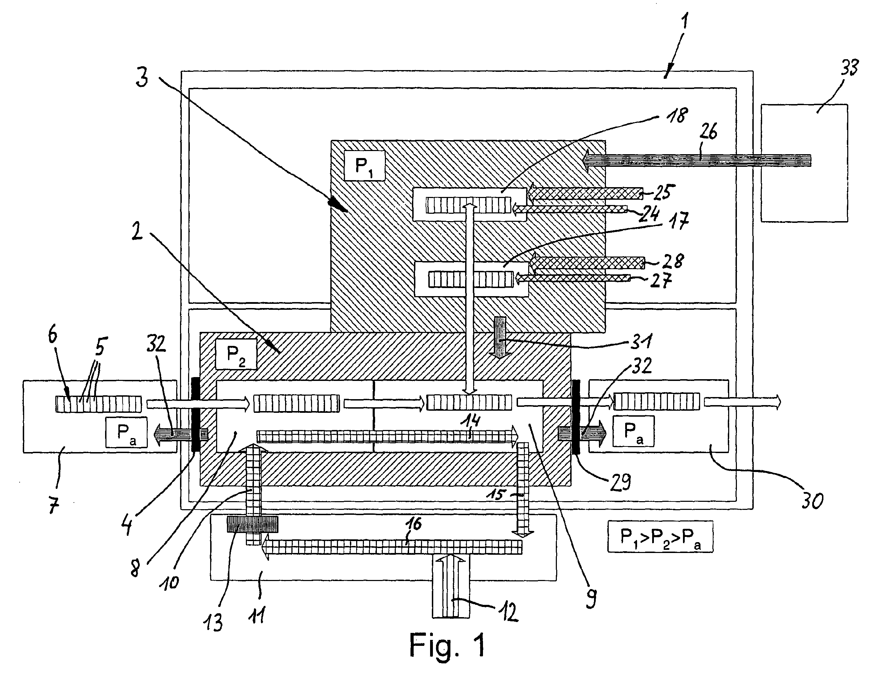

Aus Figur 1 ist ein Handler 1 mit einer Temperaturkammer 2 und einer Testkammer 3 ersichtlich. Die Temperaturkammer 2 weist einen Einlass 4 auf, über den ein Streifen 6 mit mehreren nebeneinander angeordneten Bauelementen 5 in die Temperaturkammer 2 eingeführt werden kann. Die Streifen 6 werden über eine Ladeeinheit 7 (Loader) dem Handler 1 zugeführt.

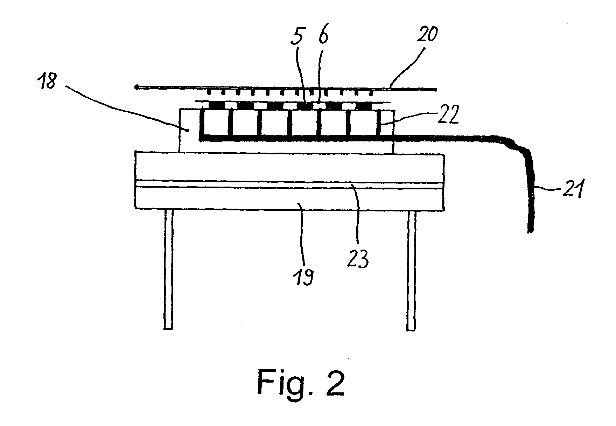

Im Folgenden wird die in den Figuren 1 und 2 gezeigte Vorrichtung anhand eines Beispiels beschrieben, bei dem die Bauelemente auf tiefe Temperaturen temperiert werden. Das erfinderische Konzept ist jedoch in gleicher Weise anwendbar, wenn Bauelemente erwärmt werden sollen.

Die Temperaturkammer 2 verfügt über einen Temperierbereich 8 (Soak-Bereich) und einen Übergabebereich 9. Die Temperierung der Bauelemente 5 in der Temperaturkammer 2 erfolgt auf konvektive Weise mittels eines kalten Gases 10, das von einer Temperiervorrichtung 11 erzeugt und in den Temperierbereich 8 der Temperaturkammer 2 eingeleitet wird. Bei der Temperiervorrichtung 11 kann es sich um eine extern am Handler 1 angeordnete, separate Einheit handeln, wie dargestellt. Alternativ ist es auch möglich, dass die Temperiervorrichtung 11 in den Handler 1 integriert ist. In der Temperiervorrichtung 11 wird flüssiger Stickstoff 12 verdampft, über eine Heizung 13 auf die gewünschte Temperatur gebracht und in gasförmiger Form dem Temperierbereich 8 der Temperaturkammer 2 zugeführt. Das kalte Gas 10, wird, wie durch den Pfeil 14 veranschaulicht, im Umluftverfahren durch die Temperaturkammer 2 hindurch zum Übergabebereich 9 und von dort wieder aus der Temperaturkammer 2 in die Temperiervorrichtung 11 zurückgeführt, wie durch den Pfeil 15 veranschaulicht ist. Innerhalb der Temperiervorrichtung 11, wird, wie durch den Pfeil 16 veranschaulicht, das kalte Gas 10 nach einer Vermischung mit dem flüssigen Stickstoff 12 wieder zur Heizung 13 zurückgeführt und von dort in den Temperierbereich 8 eingeleitet.

Nachdem der Streifen 6 mit den Bauelementen 5 im Temperierbereich 8 auf die gewünschte Temperatur temperiert worden ist, wird er zum Übergabebereich 9 transportiert. Der Streifen 6 kann von dort anschließend mittels einer Transporteinrichtung 17 (Pick and Place Einrichtung) zu einem Kontaktiernest 18 transportiert werden, das in der Testkammer 3 angeordnet ist. Derartige Transporteinrichtungen sind bekannt, so dass sie nicht näher erörtert werden müssen.

Das Kontaktiernest 18 ist, wie aus Figur 2 näher ersichtlich, üblicherweise auf einer Hubplatte 19 angeordnet, um das Kontaktiernest 18 und damit den auf dem Kontaktiernest 18 aufliegenden Streifen 6 mit den Bauelementen 5 auf eine Höhe anzuheben, in der eine Kontakteinrichtung 20 auf die elektrischen Kontakte der Bauelemente 5 aufgesetzt werden kann. In das Kontaktiernest 18 wird über eine Leitung 21 gleichmäßig temperiertes Gas zugeführt, dessen Temperatur der Testtemperatur entspricht. Von der Leitung 21 zweigen eine Vielzahl von Auslassleitungen 22 ab, um sämtliche Bauelemente 5 des Streifens 6 von unten her gleichmäßig mit dem temperierten Gas zu beaufschlagen. Die Bauelemente 5 werden im Kontaktiernest 18 somit konduktiv über das Kontaktiernest 18 und/oder durch direkte Beaufschlagung eines entsprechend temperierten Gases auf die gewünschte Testtemperatur gebracht.

Weiterhin ist es auch möglich, dass die Hubplatte 19 über eine Heizeinrichtung 23, beispielsweise eine Heizfolie, verfügt, mit der die Temperatur der Hubplatte 19 und damit diejenige des Kontaktiernests 18 in gewünschter Weise eingestellt werden kann.

Die direkte Beaufschlagung der Bauelemente 5 innerhalb des Kontaktiernests 18 mit temperiertem Gas ist in Figur 1 mit dem Pfeil 24 symbolisiert. Die zusätzliche oder alternative konduktive Temperierung des Kontaktiernests 18, die insbesondere über die Hubplatte 19 erfolgen kann, ist mit dem Pfeil 25 symbolisiert.

Weiterhin kann, wie durch den Pfeil 26 symbolisiert, in die Testkammer 3 ein trockenes Gas, insbesondere in der Form von getrockneter Umgebungsluft, eingeleitet werden. Dieses trockene Gas dient insbesondere zur Verhinderung von Kondensationsvorgängen an der Wand der Testkammer 3.

Optional ist es auch möglich, wie durch die Pfeile 27, 28 symbolisiert, die Bauelemente 5 in der Transporteinrichtung 17 indirekt und/oder direkt zu temperieren.

Nach erfolgtem Test wird der Streifen 6 mit den Bauelementen 5 mittels der Transporteinrichtung 17 vom Kontaktiernest 18 zurück in den Übergabebereich 9 der Temperaturkammer 2 gebracht und kann anschließend mittels einer geeigneten Transporteinrichtung über einen Auslass 29 aus der Temperaturkammer 2 entfernt werden. Zweckmäßigerweise werden dabei die Bauelemente 5 zunächst in einen Temperaturangleichbereich 30 (Desoak-Bereich) transportiert, der sich innerhalb des Handlers 1 befindet und eine Erwärmung bzw. Abkühlung der Bauelemente auf Umgebungstemperatur ermöglicht. Von dort können die Bauelemente 5 aus dem Handler 1 entfernt werden.

Das durch den Pfeil 26 symbolisierte trockene Gas wird der Testkammer 3 derart zugeführt, dass der Druck P₁ in der Testkammer 3 höher ist als der Druck P₂ in der Temperaturkammer 2. Der Druck P₂ in der Temperaturkammer 2 ist wiederum höher als der Umgebungsdruck Pₐ, der in der Ladeeinheit 7 und im Temperaturangleichbereich 30 herrscht. Auf diese Weise wird sichergestellt, dass das in die Testkammer 3 eingeführte trockene Gas (Pfeil 26) unidirektional von der Testkammer 3 zur Temperaturkammer 2 und von dort entweder in die Ladeeinheit 7 oder in den Temperaturangleichbereich 30 strömt, wie durch die Pfeile 31, 32 symbolisiert. Um in jedem Fall ein Eindringen von feuchter Umgebungsluft in die Temperaturkammer 2 zu verhindern, werden Einlass 4 und Auslass 29 der Temperaturkammer 2 nicht gleichzeitig, sondern abwechselnd geöffnet bzw. geschlossen.

Wie in Figur 1 angedeutet, sind die Temperaturkammer 2 und die Testkammer 3 modular aufgebaut und direkt nebeneinander angeordnet. Da lediglich in der Temperaturkammer 2 die Temperierung der Bauelemente 5 auf konvektive Weise erfolgt, ist es lediglich erforderlich, die Temperaturkammer 2 umfangreich zu isolieren, während die Testkammer 3 überhaupt nicht oder nur minimal isoliert werden muss.

## Patentansprüche

1. Verfahren zum Temperieren von elektronischen Bauelementen (5) innerhalb eines Handlers (1) für einen Funktionstest, wobei die Bauelemente (5) zunächst in einer Temperaturkammer (2) mittels Konvektion eines Gases auf eine bestimmte Temperatur vortemperiert und anschließend in einer Testkammer (3) direkt konduktiv durch Kontakt mit einem temperierten Kontaktiernest (18) und/oder durch direktes gezieltes Anströmen der im Kontaktiernest (18) angeordneten Bauelemente (5) mit temperiertem Gas auf die Testtemperatur temperiert werden, wobei die Temperaturkammer (2) einen Einlass (4) zum Einführen der Bauelemente (5) in die Temperaturkammer (2) und einen Auslass (29) zum Entfernen der Bauelemente (5) aus der Temperaturkammer (2) aufweist, und wobei der Gasdruck innerhalb der Temperaturkammer (2) und Testkammer (3) höher als der Umgebungsdruck (Pₐ) gehalten wird, **dadurch gekennzeichnet, dass** der Gasdruck (P₁) innerhalb der Testkammer (3) höher als der Gasdruck (P₂) innerhalb der Temperaturkammer (2) gehalten wird, und dass der Einlass (4) und der Auslass (29) abwechselnd geöffnet und geschlossen werden, so dass eine unidirektionale Gasströmung von der Testkammer (3) in die Temperaturkammer (2) und von dieser in die Umgebung stattfindet.

2. Verfahren nach Anspruch 1, **dadurch gekennzeichnet, dass** in die Testkammer (3) zusätzlich trockenes Gas eingeleitet wird.

3. Verfahren nach Anspruch 2, **dadurch gekennzeichnet, dass** das trockene Gas aus getrockneter Umgebungsluft besteht.

4. Vorrichtung zum Temperieren von elektronischen Bauelementen (5) innerhalb eines Handlers (1) für einen Funktionstest, mit einer Temperaturkammer (2), in der die Bauelemente (5) mittels Konvektion eines in der Temperaturkammer (2) eingeführten Gases auf eine bestimmte Temperatur vortemperiert werden, und einer ein Kontaktiernest (18) für die Bauelemente (5) aufweisenden Testkammer (3), in der die Temperierung der Bauelemente (5) auf die Testtemperatur direkt konduktiv durch Kontakt mit einem temperierten Kontaktiernest (18) und/oder durch direktes gezieltes Anströmen der Bauelemente (5) mit temperiertem Gas erfolgt, wobei der Gasdruck innerhalb der Temperaturkammer (2) und Testkammer (3) höher als der Umgebungsdruck (Pₐ) ist, und wobei die Temperaturkammer (2) einen Einlass (4) zum Einführen der Bauelemente (5) in die Temperaturkammer (2) und einen Auslass (29) zum Entfernen der Bauelemente (5) aus der Temperaturkammer (2) aufweist, **dadurch gekennzeichnet, dass** der Gasdruck (P₁) innerhalb der Testkammer (3) höher als der Gasdruck (P₂) innerhalb der Temperaturkammer (2) ist, und dass der Einlass (4) und der Auslass (29) derart gesteuert sind, dass sie abwechselnd öffnen und schließen.

5. Vorrichtung nach Anspruch 4, **dadurch gekennzeichnet, dass** die Testkammer (3) mit einer Versorgungseinrichtung (33) für trockenes Gas in Verbindung steht.

6. Vorrichtung nach Ansprüche 4 oder 5, **dadurch gekennzeichnet, dass** Temperaturkammer (2) und Testkammer (3) jeweils als Einzelmodule ausgebildet sind.

## Claims

1. Method for tempering electronic components (5) within a handler (1) for a functional test, wherein the components (5) are initially pre-tempered to a certain temperature in a temperature chamber (2) by convecting a gas and are then directly tempered in a conductive manner to the test temperature in a test chamber (3) by contact with a tempered contacting nest (18) and/or by directly controlled convection of the components (5), arranged in the contacting nest (18), with tempered gas, wherein the temperature chamber (2) has an inlet (4) for introducing the components (5) into the temperature chamber (2) and an outlet (29) for removing the components (5) from the temperature chamber (2), and wherein the gas pressure inside the temperature chamber (2) and test chamber (3) is held greater than the ambient pressure (Pₐ) **characterized in that** the gas pressure (P₁) inside the test chamber (3) is held greater than the gas pressure (P₂) inside the temperature chamber (2), and **in that** the inlet (4) and outlet (29) are alternately opened and closed, so that a unidirectional gas flow from the test chamber (3) into the temperature chamber (2) and from this to the environment takes place.

2. Method according to Claim 1, **characterized in that** dry gas is additionally introduced into the test chamber (3).

3. Method according to Claim 2, **characterized in that** the dry gas consists of dried ambient air.

4. Device for tempering electronic components (5) within a handler (1) for a functional test, with a temperature chamber (2), in which the components (5) are pre-tempered to a certain temperature by convecting a gas introduced into the temperature chamber (2), and a test chamber (3) comprising a contacting nest (18) for the components (5), in which the components (5) are directly tempered in a conductive manner to the test temperature by contact with a tempered contacting nest (18) and/or by directly controlled convection of the tempered gas against the components (5), wherein the gas pressure inside the temperature chamber (2) and test chamber (3) is greater than the ambient pressure (Pₐ), and wherein the temperature chamber (2) comprises an inlet (4) for introducing the components into the temperature chamber (2) and an outlet (29) for removing the components (5) from the temperature chamber (2), **characterized in that** the gas pressure (P₁) inside the test chamber (3) is greater than the gas pressure (P₂) inside the temperature chamber (2), and **in that** the inlet (4) and outlet (29) are controlled in such a way that they are alternately opened and closed.

5. Device according to Claim 4, **characterized in that** the test chamber (3) is connected to a supply installation (33) for dry gas.

6. Device according to Claim 4 or 5, **characterized in that** temperature chamber (2) and test chamber (3) are in each case designed as single modules.

## Revendications

1. Procédé pour tempérer des composants électroniques (5) à l'intérieur d'une monture (1) pour un test fonctionnel, dans lequel les composants (5) sont tout d'abord prétempérés dans une chambre à température (2) au moyen de la convection d'un gaz jusqu'à une température déterminée, et sont ensuite tempérés dans une chambre de test (3) directement par conduction par contact avec une niche de mise en contact tempérée (18) et/ou par afflux ciblé direct d'un gaz tempéré à la température de test sur les composants (5) agencés dans la niche de mise en contact (18), ladite chambre à température (2) comportant une entrée (4) pour l'introduction des composants (5) dans la chambre à température (2) et une sortie (29) pour l'enlèvement des composants (5) hors de la chambre à température (2), et dans lequel la pression du gaz à l'intérieur de la chambre à température (2) et de la chambre de test (3) est maintenue supérieure à la pression environnante (Pa),
**caractérisé en ce que** la pression du gaz (P1) à l'intérieur de la chambre de test (3) est maintenue supérieure à la pression du gaz (P2) à l'intérieur de la chambre à température (2), et **en ce que** l'entrée (4) et la sortie (29) sont ouvertes et fermées en alternance, de sorte qu'il se produit un écoulement de gaz unidirectionnel depuis la chambre de test (3) jusque dans la chambre à température (2), et depuis celle-ci jusque dans l'environnement.

2. Procédé selon la revendication 1, **caractérisé en ce que** l'on introduit en supplément un gaz sec dans la chambre de test (3).

3. Procédé selon la revendication 2, **caractérisé en ce que** le gaz sec est de l'air ambiant asséché.

4. Dispositif pour tempérer des composants électroniques (5) à l'intérieur d'une monture (1) pour un test fonctionnel, comprenant une chambre à température (2), dans laquelle les composants (5) sont prétempérés à une température déterminée au moyen de la convection d'un gaz introduit dans la chambre à température (2), et une chambre de test (3) qui présente une niche de mise en contact (18) pour les composants (5), dans laquelle la températion des composants (5) à la température de test a lieu directement par conduction par contact avec une niche de mise en contact tempérée (18) et/ou par afflux ciblé direct de gaz tempéré vers les composants (5), la pression du gaz à l'intérieur de la chambre à température (2) et de la chambre de test (3) étant supérieure à la pression environnante (Pa), et la chambre à température (2) comporte une entrée (4) pour l'introduction des composants (5) dans la chambre à température (2) et une sortie (29) pour l'enlèvement des composants (5) hors de la chambre à température (2),
**caractérisé en ce que** la pression du gaz (P1) à l'intérieur de la chambre de test (3) est supérieure à la pression du gaz (P2) à l'intérieur de la chambre à température (2), et **en ce que** l'entrée (4) et la sortie (29) sont commandées de telle façon qu'elles s'ouvrent et se ferment en alternance.

5. Dispositif selon la revendication 4, **caractérisé en ce que** la chambre de test (3) est en liaison avec un système d'alimentation (33) en gaz sec.

6. Dispositif selon les revendications 4 ou 5, **caractérisé en ce que** la chambre à température (2) et la chambre de test (3) sont réalisées respectivement sous forme de modules individuels.
